# FASCICULE DE BREVET EUROPEEN

(11) **EP 2 500 937 B1**
(45) Date de publication et mention de la délivrance du brevet: **27.05.2020**
(21) Numéro de dépôt: 12305316.7
(22) Date de dépôt: 16.03.2012
(51) Int. Cl.: H01L 23/367, H01L 23/373

(54) **Circuit électronique à double couche isolante et son procéde de fabrication**
Elektronischer Schaltkreis mit Doppelisolierschicht, und sein Herstellungsverfahren
Electronic circuit with double insulating layer and method for manufacturing same

(30) Priorité: 17.03.2011 FR 1152179
(43) Date de publication de la demande: 19.09.2012
(73) Titulaire: Valeo Systèmes de Contrôle Moteur, 95800 Cergy (FR)
(72) Inventeur: Dupuis, Dominique, 95820 Bruyeres Sur Oise (FR); Thomelin, Stéphane, 78550 Richebourg (FR)

(56) Documents cités:
- EP-A2- 2 053 654
- WO-A1-2007/040694
- JP-A- H09 116 091
- JP-A- 2010 098 128
- US-A- 5 347 091
- US-A- 5 923 084
- US-A1- 2003 169 575
- US-A1- 2003 214 049
- US-A1- 2004 120 121
- US-A1- 2004 212 073
- US-B1- 6 787 896

## Description

La présente invention concerne le domaine des circuits électroniques, en particulier les circuits de forte puissance.

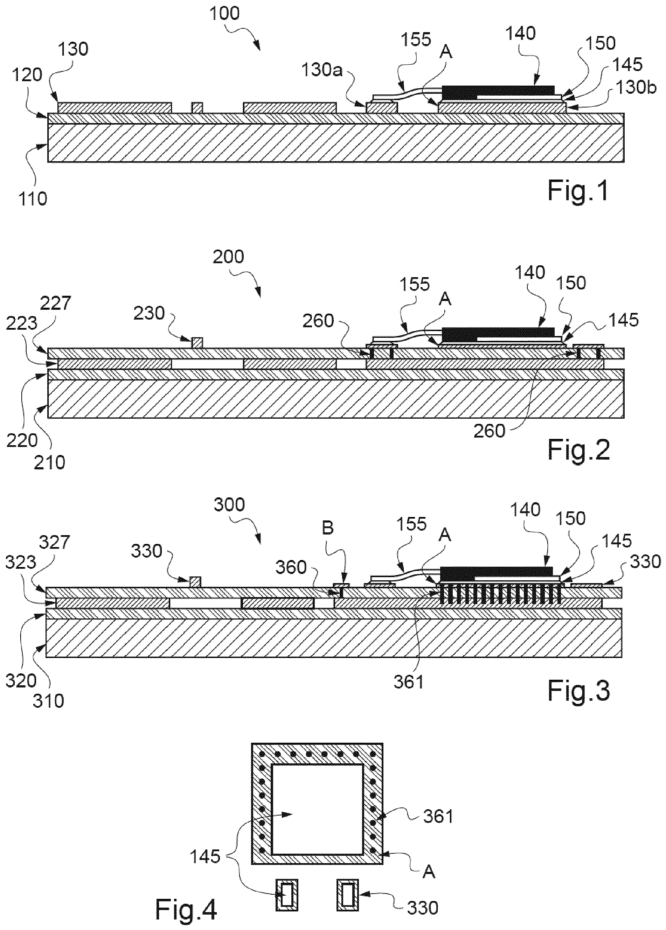

On connaît des circuits à support métallique isolé ou SMI (« Subtrat Métal Insulator » en anglais) permettant de transporter des signaux de forte puissance. La figure 1 présente un exemple de circuit SMI 100. Le circuit 100 comprend une première couche 110, ou substrat, conductrice thermiquement ; une seconde couche 120 isolante électriquement et une troisième couche 130 conductrice électriquement.

Typiquement, la troisième couche 130 comprend au moins une portion A apte à recevoir des composants 140. Ainsi, la troisième couche 130 permet de monter des composants 140 sur l'empilement de couches 110, 120, 130. La troisième couche 130 présente en outre des pistes 130a, 130b définissant un schéma électrique. La troisième couche 130 comprend une piste 130a dite « piste de signal » assurant le passage de courants faibles et une piste 130b dite « piste de puissance » assurant le passage de courants forts, principalement pour alimenter les composants 140.

Une connexion 155 assure le passage du courant provenant de la piste de signal 130a vers le composant 140. La première couche 110 conductrice permet de dissiper la chaleur produite par les courants électriques parcourant les pistes 130a, 130b et les composants 140. La seconde couche 120 assure une isolation électrique entre les première 110 et troisième 130 couches. Cependant la seconde couche 120 permet le passage de la chaleur provenant de la troisième couche 130 vers la première couche 110.

Dans l'exemple présenté en figure 1, le composant 140 est monté avec un refroidisseur 150 améliorant le refroidissement du composant 140. Typiquement le refroidisseur est une plaque plane.

Les circuits SMI 100 ne permettent un routage électrique que sur une seule couche 130.

On connaît des circuits SMI double couche permettant d'améliorer la densité de routage électrique.

La figure 2 présente un exemple de circuit SMI double couche 200. Par rapport au circuit SMI 100, le dispositif SMI double couche 200 présente une couche conductrice 223 et une couche isolante 227 supplémentaire. Ainsi, le dispositif 200 comprend une première couche 210 conductrice thermiquement, une seconde couche 220 isolante électriquement, une troisième couche 223 conductrice électriquement, une quatrième couche 227 isolante électriquement et une cinquième couche 230 conductrice électriquement. Le routage du schéma électrique est réalisé avec les deux couches conductrices 223, 230. Ainsi la densité de routage est améliorée. Les deux couches conductrices 223, 230 sont reliées par des trous d'interconnexion électrique 260 pour un passage de courant.

Cependant, la réponse thermique du circuit SMI double couche est dégradée par rapport à un simple circuit SMI 100. En effet, la chaleur issue de la couche 230 doit traverser deux couches isolantes 220, 227 pour rejoindre la première couche 210.

En outre, lorsque les trous d'interconnexion électrique 260 ont de grands diamètres, les trous d'interconnexion électrique 260 sont typiquement réalisés en déposant un revêtement de matériau conducteur électrique sur les parois du trou. La partie centrale du trou reste libre en matériau conducteur électrique. Cependant, l'air présent dans la partie centrale du trou s'échauffe entraînant l'apparition de points chauds dans le circuit 300. La dissipation de chaleur dans le circuit 300 est alors réduite.

Le document US2004/0120121A1 présente un circuit électronique dans lequel des trous d'interconnexion thermique relient des couches de conducteurs électriques séparées par des couches d'isolants électriques. Dans ce document dès qu'un trou d'interconnexion thermique est ménagé dans une couche, il traverse cette couche.

Le document JP2010098128A présente également un circuit électronique dans lequel des trous d'interconnexion thermique relient des couches de conducteurs électriques séparées par des couches d'isolants électriques. Dans ce document dès qu'un trou d'interconnexion thermique est ménagé dans une couche, il traverse cette couche.

Il existe donc un besoin pour un dispositif double couche permettant une dissipation thermique améliorée et un procédé de fabrication d'un tel dispositif.

A cet effet, l'invention propose un circuit électronique selon la revendication 1.

On utilise les propriétés de conduction thermique des trous d'interconnexion thermique pour dissiper la chaleur produite par des composants montés sur le circuit. Ainsi, le refroidissement des composants est amélioré par rapport à un SMI double couche selon l'art antérieur.

Selon une première variante, les trous d'interconnexion sont des trous remplis d'un matériau conducteur thermique. Ainsi, la capacité de transmission de chaleur des trous d'interconnexion thermique est maximale.

Selon une seconde variante, les trous d'interconnexion sont des trous comprenant un revêtement intérieur en un premier matériau conducteur thermique. Ainsi, le temps et les coûts de fabrication du circuit selon l'invention sont réduits.

Selon un mode de réalisation particulier de la seconde variante, les trous d'interconnexion comprennent en outre, dans leur partie centrale, un second matériau conducteur thermique. Ainsi, les trous d'interconnexion thermique ne comprennent pas d'air, qui est un mauvais conducteur thermique et générateur de défauts liés à la dilatation thermique de l'air, dans leur partie centrale.

Selon un premier mode de réalisation alternatif, les trous d'interconnexion sont répartis dans une zone périphérique de la portion apte à recevoir un composant électronique. Ainsi, les trous d'interconnexion thermique sont simplement obtenus.

Selon un second mode de réalisation alternatif, les trous d'interconnexion sont répartis sur la totalité de la portion apte à recevoir un composant électronique. Ainsi, la transmission de la chaleur d'un composant monté sur le circuit à la troisième couche de conducteur électrique est améliorée par rapport au circuit selon le premier mode de réalisation alternatif. En outre, la surface de la portion apte à recevoir un composant peut être inférieure à celle de la portion correspondante dans le premier mode de réalisation alternatif.

Selon un mode de réalisation particulier, le circuit comprend en outre, entre une couche d'isolant électrique et une couche de conducteur électrique, une pluralité de couches de conducteur électrique séparées entre elles par des couches d'isolant électrique, des trous d'interconnexion thermique reliant les couches de conduction électrique entre elles. Ainsi, le degré de liberté du schéma électrique du circuit selon l'invention est amélioré.

L'invention concerne en outre un procédé de fabrication du circuit électronique selon la revendication 8.

Grâce au procédé selon l'invention, en particulier à l'étape de réalisation de trous d'interconnexion thermique, il est obtenu un dispositif ayant un refroidissement des composants amélioré par rapport à un SMI double couche selon l'art antérieur.

Selon une première variante, la réalisation des trous d'interconnexion thermique comprend le bouchage des trous par un matériau conducteur thermique. Ainsi, la capacité de transmission de chaleur des trous d'interconnexion thermique est maximale.

Selon une seconde variante, la réalisation des trous d'interconnexion thermique comprend le dépôt d'un revêtement de matériau conducteur thermique sur les parois des trous. Ainsi, le procédé présente un temps et des coûts de fabrication réduits.

Selon un mode de réalisation particulier, la fixation du second empilement sur le premier empilement comprend le pressage du second empilement sur le premier empilement. Ainsi, la matière de la seconde couche d'isolant électrique peut fluer dans la partie centrale des trous d'interconnexion thermique. Alors, les trous d'interconnexion thermique ne présentent pas de poches d'air qui diminuent la transmission de chaleur de la cinquième couche vers la troisième couche de conducteur électrique.

D'autres caractéristiques et avantages de l'invention apparaîtront à la lecture de la description qui suit de modes de réalisation de l'invention données à titre d'exemple et en référence aux figures annexées qui montrent :
- figure 1, déjà décrite, une vue en coupe d'un circuit SMI simple selon l'art antérieur ;
- figure 2, déjà décrite, une vue en coupe d'un circuit SMI double couche selon l'art antérieur ;
- figure 3, une vue en coupe d'un premier exemple de circuit électronique selon l'invention ;
- figure 4, une vue de dessus partielle d'un circuit électronique selon la première variante et le premier mode de réalisation alternatif de l'invention ;
- figure 5, une vue de dessus partielle d'un circuit électronique selon la seconde variante et le premier mode de réalisation alternatif ;
- figure 6, une vue de dessus partielle d'un circuit électronique selon la seconde variante et le second mode de réalisation alternatif ;
- figure 7, une vue en coupe d'un second exemple de circuit électronique selon l'invention ;
- figure 8, une vue en coupe d'un troisième exemple de circuit électronique selon l'invention ;
- figure 9, un schéma illustrant une seconde étape d'un procédé selon l'invention ;
- figure 10, un schéma illustrant une troisième étape d'un procédé selon l'invention ;
- figure 11, un schéma illustrant encore une quatrième étape d'un procédé selon l'invention ;
- figure 12, une vue en coupe d'un quatrième exemple de circuit électronique selon l'invention.

L'invention sera mieux comprise en faisant référence aux figures 3, 7, 8 et 12 qui présentent respectivement des vues en coupe d'un premier, un second, un troisième et un quatrième exemple de circuit électronique 300 selon l'invention.

Le circuit électronique 300 est un empilement comprenant une couche conductrice thermique 310, des couches conductrices électriques 323, 330 et des couches conductrices isolantes 320, 327. Le circuit électronique 300 reçoit des composants électroniques 140 à sa surface.

Le circuit électronique 300 comprend une première couche 310 d'un conducteur thermique (encore désigné par le terme « substrat ») qui permet de dissiper la chaleur produite par les courants circulant dans le circuit électronique 300. La première couche 310 est par exemple en cuivre ou en aluminium.

Le circuit électronique 300 comprend en outre une seconde couche 320 d'un isolant électrique. La seconde couche 320 d'isolant assure l'isolation électrique entre les courants circulant dans des couches supérieures du circuit 300 et la première couche 310. Cependant, la seconde couche 320 a une conduction thermique permettant une transmission de la chaleur produite dans les couches supérieures vers la première couche 310. La conduction thermique est par exemple fonction de l'épaisseur de la couche isolante 320.

Une troisième couche 323 de conducteur électrique permet de transmettre des courants aux composants 140 montés sur le circuit électronique 300. La troisième couche 323 comprend des pistes réalisant un schéma électrique.

Une quatrième couche 327 d'isolant électrique sépare la troisième couche 323 avec une cinquième couche 330 de conducteur électrique. La troisième couche d'isolant 327 isole électriquement entre elles les troisième 323 et cinquième 330 couches de conducteur électrique. Par exemple, la quatrième couche 327 est identique à la seconde couche 320 d'isolant électrique. Par exemple, les seconde 320 et troisième 327 couches d'isolant électrique sont en un tissage de fibre de verre enrobé de résine epoxy.

La cinquième couche 330 de conducteur électrique permet de transmettre des courants aux composants 140 montés sur le circuit électronique 300. La cinquième couche 330 comprend des pistes réalisant un schéma électrique. La cinquième couche 330 comprend en outre au moins une portion A apte à recevoir le composant 140. Par exemple, les troisième 323 et cinquième 330 couches sont en un matériau métallique tel que le cuivre.

Des trous d'interconnexion électrique 360 assurent le passage de courants entre les troisième 323 et cinquième 330 couches. Les trous d'interconnexion 360 sont connus en soi. Par exemple, les trous d'interconnexion 360 sont des trous métallisés.

Le circuit électronique 300 comprend en outre des trous d'interconnexion thermique 361 ou 362 qui relient la portion A de la cinquième couche 330 à la troisième couche 323. Les trous d'interconnexion thermique 361 ou 362 sont des trous comprenant un matériau conducteur thermique. Dans le circuit électronique 300 selon l'invention, la chaleur produite par le composant 140 est transmise à travers la quatrième couche 327 d'isolant électrique vers la troisième couche 323 de conducteur électrique. En outre, la chaleur du composant 140 est transmise par l'intermédiaire des trous d'interconnexion thermique 361 ou 362 à la troisième couche 323. La chaleur de la troisième couche 323 est ensuite transmise à travers la seconde couche 310 jusqu'à la première couche 310 de conducteur thermique pour une dissipation de la chaleur produite dans le circuit 300. Les trous d'interconnexion thermique 361 ou 362, en particulier leur diamètre et leur nombre, sont fonction de l'énergie thermique du composant 140 à dissiper. On utilise les propriétés de conduction thermique des trous d'interconnexion thermique 361 ou 362 pour dissiper la chaleur produite par les composants 140. Ainsi, le refroidissement des composants 140 est amélioré par rapport à un SMI double selon l'art antérieur.

Par exemple, le circuit 300 comprend en outre un refroidisseur ou drain thermique 150 pour améliorer le refroidissement du composant 140. Le refroidisseur est un organe métallique permettant la dissipation de la chaleur produite par le composant 140.

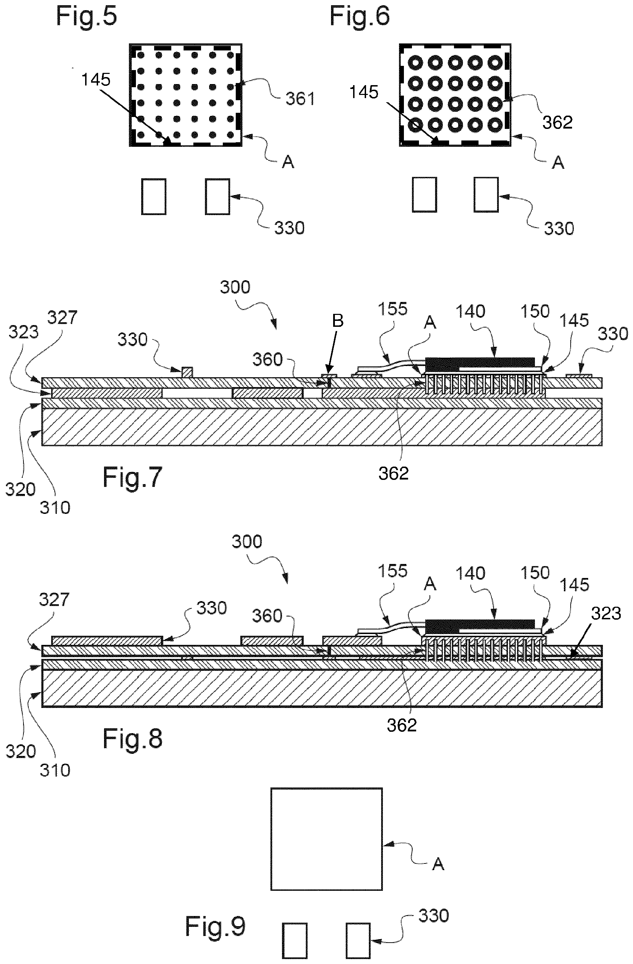

Les figures 3 et 7 illustrent un premier mode de réalisation du circuit électronique 300. Les trous d'interconnexion thermique 361 ou 362 sont des trous traversants par rapport à la cinquième couche 330 de conducteur électrique. Autrement dit, les trous d'interconnexion thermique 361 ou 362 traversent toute l'épaisseur de la cinquième couche 330 de conducteur électrique. Les trous d'interconnexion thermique 361 ou 362 traversent également la quatrième couche 327 d'isolant électrique. Cependant, les trous d'interconnexion thermique 361 ou 362 sont non traversants par rapport à la troisième couche 323 de conducteur électrique. Autrement dit, les trous d'interconnexion thermique 361 ou 362 ne traversent pas toute l'épaisseur de la troisième couche 323 de conducteur électrique.

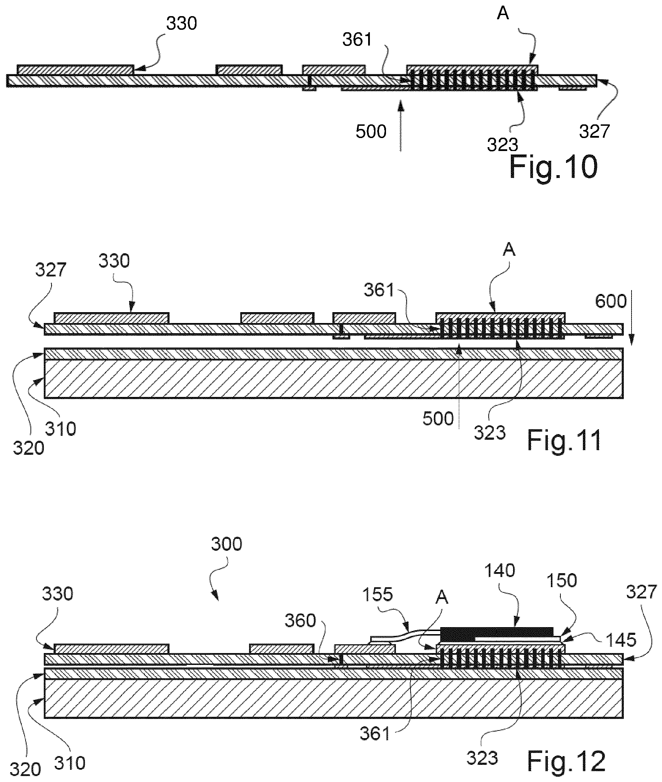

Les figures 8 et 12 illustrent un second mode de réalisation du circuit électronique 300. Les trous d'interconnexion thermique 361 ou 362 sont des trous traversants par rapport à la troisième couche 323. Les trous d'interconnexion thermique 361 ou 362 traversent également la quatrième couche 327 d'isolant électrique. Cependant, les trous d'interconnexion thermique 361 ou 362 sont non traversants par rapport à la cinquième couche 330 de conducteur électrique.

Les trous d'interconnexion thermique 361 sont conformés pour assurer la transmission de chaleur des composants 140 vers la première couche 310 de conducteur thermique.

Selon une première variante illustrée en figures 3, 4, 5 et 12, les trous d'interconnexion thermique sont des trous 361 remplis d'un matériau conducteur thermique. Ainsi, la capacité de transmission de chaleur des trous d'interconnexion thermique est maximale. Le matériau conducteur thermique est par exemple un métal tel que le cuivre. Cette première variante est particulièrement adaptée au cas où le diamètre des trous d'interconnexion est faible, par exemple inférieur à 130µm.

Selon une seconde variante illustrée en figure 6, 7 et 8, les trous d'interconnexion thermique sont des trous 362 comprenant un revêtement intérieur en un premier matériau conducteur thermique. Le premier matériau conducteur thermique est par exemple un métal tel que le cuivre. Les trous d'interconnexion thermique sont des trous 362 non bouchés par le premier matériau conducteur thermique. Le premier matériau conducteur thermique forme un revêtement sur la paroi des trous 362. Cette seconde variante est particulièrement adaptée au cas où le diamètre des trous d'interconnexion est élevé, par exemple supérieur à 130µm. Le revêtement intérieur permet d'obtenir une conduction thermique sans boucher le trou 362. Le trou 362 comprenant un revêtement intérieur présente moins de matériau conducteur thermique que s'il était bouché. Ainsi, la quantité de premier matériau conducteur thermique utilisée est diminuée. Les coûts de fabrication du circuit 300 sont donc réduits. En outre, le dépôt du premier matériau conducteur thermique dans les trous 362 est moins long puisque le trou 362 n'est pas bouché par le premier matériau conducteur thermique. Ainsi, le temps de fabrication du circuit 300 est diminué.

La figure 8 illustre un mode de réalisation particulier de la seconde variante du circuit électronique 300. Les trous 362 comprennent en outre un second matériau conducteur thermique dans leur partie centrale. Ainsi, les trous 362 ne comprennent pas d'air, qui est un mauvais conducteur thermique, dans leur partie centrale. Par exemple, le second matériau conducteur thermique est moins cher que le premier matériau conducteur thermique et présente une conduction thermique inférieure à celle du premier matériau. Ainsi, un trou 362 dans un circuit dans le mode de réalisation particulier de la seconde variante présente une conduction thermique améliorée par le second matériau conducteur thermique, tout en limitant la quantité de premier matériau utilisée.

La figure 4 présente un exemple de répartition des trous d'interconnexion thermique 361 ou 362 selon un premier mode de réalisation alternatif. La portion A comprend une pâte à braser ou joint 145 dans une zone centrale. La pâte à braser 145 permet la fixation du composant 140 sur la portion A. La pâte à braser 145 permet en outre la fixation d'une connexion électrique 155 sur une piste de la cinquième couche 330 de conducteur électrique. Dans ce premier mode de réalisation alternatif, les trous d'interconnexion thermique 361 ou 362 sont répartis dans une zone périphérique de la portion A. Ainsi, les trous d'interconnexion thermique 361 ou 362 sont simplement obtenus.

Les figures 5 et 6 présentent des exemples de répartition des trous d'interconnexion thermique 361 ou 362 selon un second mode de réalisation alternatif. La pâte à braser 145 est délimitée par des pointillés. Les trous d'interconnexion thermique 361 ou 362 sont répartis sur la totalité de la portion A sous la pâte à braser 145. Ainsi, à surface de portion A égale, le circuit 300 selon ce second mode de réalisation alternatif présente plus de trous d'interconnexion thermique 361 ou 362 que dans le mode de réalisation précédent. Ainsi, la transmission de la chaleur du composant 140 à la troisième couche 323 de conducteur électrique est améliorée par rapport au circuit 300 selon le premier mode de réalisation alternatif. En outre, les trous d'interconnexion thermique 361 ou 362 sont positionnés sous la pâte à braser 145. Ainsi, la surface de la portion A peut être inférieure à celle de la portion A du premier mode de réalisation alternatif.

Selon un mode de réalisation particulier du circuit selon l'invention, le circuit électronique 300 comprend en outre plusieurs couches de conducteur électrique séparées entre elles par des couches d'isolant électrique. Autrement dit, le circuit électronique 300 selon ce mode de réalisation particulier comprend un empilement de couches électriques et de couches d'isolant électrique agencées alternativement. Cet empilement de couches est compris entre une couche 320, 327 d'isolant électrique et une couche 323, 330 de conducteur électrique. Cet empilement de couches améliore le degré de liberté du schéma électrique du circuit 300. L'empilement de couches de conducteur électrique et d'isolant électrique comprend des trous d'interconnexion thermique reliant les couches de conduction électrique entre elles. Les trous d'interconnexion thermique sont fonction de la chaleur à transmettre à travers l'empilement jusqu'à la première couche 310. En particulier, le diamètre et le nombre de trous d'interconnexion sont fonction de l'énergie thermique à dissiper. Par exemple, les trous d'interconnexion de l'empilement de couche présentent des caractéristiques identiques aux trous d'interconnexion 361 ou 362 décrits dans les autres modes de réalisation.

Dans un second mode de réalisation particulier, les trous d'interconnexion thermique 361 ou 362 permettent en outre une connexion électrique du composant 140 avec des pistes de la troisième couche 323 de conducteur électrique. Ainsi, le circuit électronique 300 présente une dissipation thermique améliorée par rapport à l'art antérieur et des connexions électriques réalisées avec les trous d'interconnexion thermique 361 ou 362. Les figures 3 et 7 présentent des exemples selon ce mode de réalisation particulier. La portion B de la cinquième couche 330 est en contact électrique avec le composant 140 par l'intermédiaire d'un via électrique 360, une piste de la couche 320, et les trous d'interconnexion thermique et électrique 361.

Dans un troisième mode de réalisation particulier, les épaisseurs des troisième 323 et cinquième 330 couches de conducteur électrique sont fonction de la densité de courant circulant en elles. La couche dite « de courants de puissance » permet le passage de courants de forte intensité. Par exemple, la couche de courants de puissance permet le passage de courants d'intensité supérieure à 1 A. Les courants de puissance permettent principalement d'alimenter les composants 140 en énergie. La couche dite «de courants de signal» permet le passage de courants de faible intensité. Par exemple, la couche de courant de signal permet le passage de courants d'intensité inférieure à 1 A. Les courants de signal subissent un traitement dans les composants 140. Typiquement, la couche de courant de puissance est plus épaisse que la couche de courant de signal.

Dans les premier et second exemples de circuit présentés en figures 3 et 7, la troisième couche 323 de conducteur électrique permet le passage de courants de puissance ; et la cinquième couche 330 conductrice permet le passage de courants de signal.

Dans les troisième et quatrième exemples de circuit présentés en figures 8 et 12, la troisième couche 323 de conducteur électrique permet le passage de courants de signal ; et la cinquième couche 330 permet le passage de courants de puissance.

En particulier, dans les troisième et quatrième exemples de circuit présentés en figures 8 et 12, l'épaisseur de la cinquième couche 330 est supérieure à celle de la cinquième couche dans les premier et second exemples. Augmenter l'épaisseur de la cinquième couche 330, en particulier l'épaisseur de la portion A, permet de stocker plus de chaleur dans la cinquième couche 330 que dans les premier et second exemples. Ainsi, plus de chaleur est transmise du composant 140 vers la cinquième couche 330 pour être ensuite transmise jusqu'à la première couche 300. En particulier lors de phénomènes transitoires, le composant 140 refroidit plus vite que dans les premier et second exemples pour des trous d'interconnexion thermique 361 ou 362 similaires en termes de diamètre, de nombre et de répartition.

L'invention concerne en outre un procédé de fabrication d'un circuit électronique selon l'invention. Le procédé sera mieux compris en faisant référence aux figures 9, 10 et 11.

Le procédé comprend la fourniture d'un premier empilement d'une première couche 310 de conducteur thermique et d'une seconde couche 320 d'isolant électrique.

Le procédé comprend en outre la fourniture d'un second empilement d'une troisième couche 323 de conducteur électrique, d'une quatrième couche 327 d'isolant électrique, d'une cinquième couche 330 de conducteur électrique. La figure 9 présente une vue partielle de la cinquième couche 330. La cinquième couche 330 comprend au moins une portion A apte à recevoir un composant électronique 140.

Les seconde 320 et quatrième 327 couches d'isolant électrique ont une conduction thermique permettant une transmission de la chaleur produite dans les couches supérieures vers la première couche 310. La conduction thermique est par exemple fonction de l'épaisseur de la couche isolante.

Puis, comme illustré en figure 10, on procède à la réalisation de trous d'interconnexion thermique 361 ou 362 entre la portion A apte à recevoir des composants électroniques 140 et la troisième couche 323 de conducteur électrique. Par exemple, le diamètre et le nombre de trous d'interconnexion thermique 361 ou 362 est fonction d'une énergie thermique de composant 140 à dissiper. On utilise les propriétés de conduction thermique des trous d'interconnexion thermique 361 ou 362 pour dissiper la chaleur produite par les composants 140. Ainsi, la réalisation de trous d'interconnexion thermique 361 ou 362 permet un refroidissement des composants 140 amélioré par rapport à un SMI double couche selon l'art antérieur.

Par exemple, les trous d'interconnexion thermique 361 ou 362 sont réalisés par perçage.

Dans un premier mode de réalisation illustré en figure 10, les trous 361 ou 362 sont percés suivant une direction 500 allant de la troisième couche 323 de conducteur électrique vers la cinquième couche 330 de conducteur électrique. Les trous 361 ou 362 sont traversants dans la troisième couche 323 de conducteur électrique et la quatrième couche 327 d'isolant électrique et non traversants dans la cinquième couche 330 de conducteur électrique.

Dans un second mode de réalisation, les trous 361 ou 362 sont percés suivant une direction allant de la cinquième couche 330 de conducteur électrique vers la troisième couche 323 de conducteur électrique. Les trous 361 ou 362 sont traversants dans la cinquième couche 330 de conducteur électrique et la quatrième couche 327 d'isolant électrique et non traversants dans la troisième couche 323 de conducteur électrique. Un exemple de circuit électronique 300 obtenu avec un procédé selon ce mode de réalisation est présenté en figure 7.

Un matériau conducteur thermique est ensuite déposé dans les trous 361 ou 362 afin de permettre une conduction thermique entre les cinquième 330 et troisième 323 couches autre que par l'intermédiaire de la quatrième couche 327 d'isolant électrique.

Selon une première variante, le matériau conducteur thermique est déposé sous forme de revêtement sur les parois des trous.

Selon une seconde variante, les trous 361 ou 362 sont bouchés avec le matériau conducteur thermique.

Le procédé comprend ensuite la fixation du second empilement sur le premier empilement. La troisième couche 323 de conducteur électrique est sur la seconde couche 320 d'isolant électrique. Dans un exemple illustré en figure 11, les premier et deuxième empilements sont fixés ensemble par un pressage à chaud suivant une direction 600 allant de la cinquième couche 330 de conducteur électrique vers la troisième couche 323 de conducteur électrique.

La figure 12 présente un exemple de circuit électronique obtenu après le montage d'un composant 140 et de connexions électriques 155.

Dans un mode de réalisation particulier, les trous d'interconnexion thermique sont des trous 362 ayant un revêtement de matériau conducteur thermique ; et sont traversants dans la troisième couche 323 de conducteur électrique et la quatrième couche 327 d'isolant électrique et non traversants dans la cinquième couche 330 de conducteur électrique. Lors de la fixation par pressage à chaud, la matière de la seconde couche 320 d'isolant électrique flue dans la partie centrale des trous 362. Ainsi, les trous 362 contiennent du matériau isolant électrique dans leur partie centrale. Le matériau isolant électrique présente en outre une conduction thermique. En remplissant les trous 362 du matériau isolant électrique, on évite la présence d'air dans ceux-ci. Ainsi, les trous 362 ne présentent pas de poches d'air qui diminuent la transmission de chaleur de la cinquième couche 330 vers la troisième couche 323. La figure 8 présente un exemple de circuit électronique obtenu avec ce mode de réalisation particulier.

L'invention ne se limite pas aux exemples décrits. Notamment, dans un exemple, le matériau conducteur thermique est en outre un conducteur électrique.

En outre, comme illustré sur les figures, les trous d'interconnexion 361, 362 peuvent ne pas s'étendre dans l'épaisseur de la première 310 et de la seconde 320 couche.

De préférence, une couche 310, 320, 323, 327, 330 est réalisée en un seul matériau. Les couches peuvent être monoblocs ou peuvent présenter des pistes réalisant un routage d'un circuit électronique.

Plus particulièrement, dans le premier mode de réalisation, les trous d'interconnexion 361, 362 ont une portion traversante dans la cinquième couche 330 et la quatrième couche 327 et une portion non traversante dans la troisième couche 323 ; et dans le deuxième mode de réalisation les trous d'interconnexion 361, 362 ont une portion traversante dans la troisième couche 323 et la quatrième couche 327 et une portion non traversante dans la cinquième couche 330.

Dans le circuit selon le second mode de réalisation, la réalisation de trous d'interconnexion 361, 362 non traversants dans la cinquième couche 330 a l'avantage de faciliter la fixation du composant 140 sur la portion A. En effet, la surface de la portion A est uniforme et régulière car non traversée par le trou 361, 362. Ceci permet d'éviter la formation de cavités lors, par exemple, du brasage du composant 140 sur la portion A. De telles cavités dans la brasure du composant diminuent la robustesse du maintien du composant 140 sur la portion A et la diffusion thermique du composant 140 vers la cinquième couche 330.

Dans le circuit selon le premier mode de réalisation, les trous 361, 362 sont traversants dans la cinquième couche. Un tel trou traversant peut favoriser l'apparition des cavités lors de la fixation du composant 140. Pour éviter de telles cavités, le trou 362, 362 peut être rempli de matière ou recouvert d'une mince couche de matière métallique.

La réalisation des trous d'interconnexion 361, 362 par perçage est un procédé simple. Les différences de dureté entre les couches 310, 320, 323, 327, 330 permettent de contrôler la profondeur des trous 361, 362 lors du perçage. Ainsi, la réalisation de court-circuit entre, par exemple, la cinquième couche 330 et la première couche 310 est facilement évitée.

## Revendications

1. Circuit électronique (300) comprenant au moins :
une première couche (310) d'un conducteur thermique ;
une seconde couche (320) d'un isolant électrique ;
une troisième couche (323) d'un conducteur électrique ;
une quatrième couche (327) d'un isolant électrique ;
une cinquième couche (330) d'un conducteur électrique, ladite cinquième couche (330) de conducteur électrique comprenant au moins une portion (A) apte à recevoir un composant électronique (140) ;
dans lequel une pluralité de trous d'interconnexion thermique (361, 362) relient la portion (A) de la cinquième couche (330) de conducteur électrique à la troisième couche (323) de conducteur électrique,
**caractérisé en ce que** les trous d'interconnexion thermique (361, 362) sont soit traversants dans la cinquième couche (330) de conducteur électrique et la quatrième couche (327) d'isolant électrique, et non traversants dans la troisième couche (323) de conducteur électrique, soit traversants dans la troisième couche (323) de conducteur électrique et la quatrième couche (327) d'isolant électrique, et non traversant dans la cinquième couche (330) de conducteur électrique.

2. Circuit électronique selon la revendication précédente, dans lequel les trous d'interconnexion thermique sont des trous (361) remplis d'un matériau conducteur thermique.

3. Circuit électronique selon la revendication 1, dans lequel les trous d'interconnexion thermique sont des trous (362) comprenant un revêtement intérieur en un premier matériau conducteur thermique.

4. Circuit électronique selon la revendication 3, dans lequel les trous (362) comprennent en outre, dans leur partie centrale, un second matériau conducteur thermique.

5. Circuit électronique selon l'une des revendications 1 à 4 dans lequel les trous d'interconnexion thermique (361, 362) sont répartis dans une zone périphérique de la portion (A) apte à recevoir un composant électronique.

6. Circuit électronique selon l'une des revendications 1 à 4 dans lequel les trous d'interconnexion thermique (361, 362) sont répartis sur la totalité de la portion (A) apte à recevoir un composant électronique.

7. Circuit électronique selon l'une des revendications précédentes comprenant en outre entre une couche d'isolant électrique (320, 327) et une couche de conducteur électrique (323, 330), une pluralité de couches de conducteur électrique séparées entre elles par des couches d'isolant électrique, des trous d'interconnexion thermique (361, 362) reliant les couches de conduction électrique entre elles.

8. Procédé de fabrication de circuit électronique comprenant :
- la fourniture d'un premier empilement d'une première couche (310) de conducteur thermique et d'une seconde couche (320) d'isolant électrique ;
- la fourniture d'un second empilement d'une troisième couche (323) d'un conducteur électrique, d'une quatrième couche (327) d'un isolant électrique, d'une cinquième couche (330) d'un conducteur électrique, la cinquième couche (330) comprenant au moins une portion (A) apte à recevoir un composant électronique (140) ;
- la réalisation de trous d'interconnexion thermique (361, 362) entre la portion (A) apte à recevoir des composants de la cinquième couche (330) de conducteur électrique et la troisième couche (323) de conducteur électrique;
- la fixation du second empilement sur le premier empilement, la troisième couche (323) étant sur la seconde couche (320) d'isolant électrique
**caractérisé en ce que** les trous d'interconnexion thermique (361, 362) entre la portion (A) apte à recevoir des composants de la cinquième couche (330) de conducteur électrique et la troisième couche (323) de conducteur électrique sont réalisés de sorte que soit les trous d'interconnexion thermique (361, 362) sont traversants dans la cinquième couche (330) de conducteur électrique et la quatrième couche (327) d'isolant électrique, et non traversants dans la troisième couche (323) de conducteur électrique, soit les trous d'interconnexion thermique (361, 362) sont traversants dans la troisième couche (323) de conducteur électrique et la quatrième couche (327) d'isolant électrique, et non traversants dans la cinquième couche (330) de conducteur électrique.

9. Procédé de fabrication de circuit électronique selon la revendication 8 dans lequel la réalisation des trous d'interconnexion thermique comprend le bouchage des trous (361) par un matériau conducteur thermique.

10. Procédé de fabrication de circuit électronique selon la revendication 8 dans lequel la réalisation des trous d'interconnexion thermique comprend le dépôt d'un revêtement de matériau conducteur thermique sur les parois des trous (362).

11. Procédé de fabrication de circuit électronique selon l'une des revendications 8 à 10 dans lequel la fixation du second empilement sur le premier empilement comprend le pressage du second empilement sur le premier empilement.

## Patentansprüche

1. Elektronischer Schaltkreis (300), der mindestens Folgendes beinhaltet:
eine erste Schicht (310) aus einem Wärmeleiter;
eine zweite Schicht (320) aus einem elektrischen Isolator;
eine dritte Schicht (323) aus einem elektrischen Leiter;
eine vierte Schicht (327) aus einem elektrischen Isolator;
eine fünfte Schicht (330) aus einem elektrischen Leiter, wobei die fünfte elektrische Leiterschicht (330) mindestens einen Abschnitt (A) beinhaltet, der fähig ist, ein elektronisches Bauteil (140) aufzunehmen;
wobei eine Vielzahl von Wärmedurchgangslöchern (361, 362) den Abschnitt (A) der fünften elektrischen Leiterschicht (330) mit der dritten elektrischen Leiterschicht (323) verbinden,
**dadurch gekennzeichnet, dass** die Wärmedurchgangslöcher (361, 362) entweder in der fünften elektrischen Leiterschicht (330) und der vierten elektrischen Isolatorschicht (327) durchgehend und in der dritten elektrischen Leiterschicht (323) nicht durchgehend sind oder in der dritten elektrischen Leiterschicht (323) und der vierten elektrischen Isolatorschicht (327) durchgehend und in der fünften elektrischen Leiterschicht (330) nicht durchgehend sind.

2. Elektronischer Schaltkreis nach dem vorhergehenden Anspruch, wobei die Wärmedurchgangslöcher Löcher (361) sind, die mit einem wärmeleitenden Material gefüllt sind.

3. Elektronischer Schaltkreis nach Anspruch 1, wobei die Wärmedurchgangslöcher Löcher (362) sind, die eine Innenbeschichtung aus einem ersten wärmeleitenden Material beinhalten.

4. Elektronischer Schaltkreis nach Anspruch 3, wobei die Löcher (362) ferner in ihrem mittigen Teil ein zweites wärmeleitendes Material beinhalten.

5. Elektronischer Schaltkreis nach einem der Ansprüche 1 bis 4, wobei die Wärmedurchgangslöcher (361, 362) in einem Randbereich des Abschnitts (A), der fähig ist, ein elektronisches Bauteil aufzunehmen, verteilt sind.

6. Elektronischer Schaltkreis nach einem der Ansprüche 1 bis 4, wobei die Wärmedurchgangslöcher (361, 362) über den gesamten Abschnitt (A), der fähig ist, ein elektronisches Bauteil aufzunehmen, verteilt sind.

7. Elektronischer Schaltkreis nach einem der vorhergehenden Ansprüche, der ferner zwischen einer elektrischen Isolatorschicht (320, 327) und einer elektrischen Leiterschicht (323, 330) eine Vielzahl von elektrischen Leiterschichten beinhaltet, die durch elektrische Isolatorschichten voneinander getrennt sind, wobei Wärmedurchgangslöcher (361, 362) die elektrischen Leitungsschichten untereinander verbinden.

8. Verfahren zur Herstellung eines elektronischen Schaltkreises, das Folgendes beinhaltet:
- Bereitstellen eines ersten Stapelaufbaus aus einer ersten Wärmeleiterschicht (310) und einer zweiten elektrischen Isolatorschicht (320);
- Bereitstellen eines zweiten Stapelaufbaus aus einer dritten Schicht (323) aus einem elektrischen Leiter, einer vierten Schicht (327) aus einem elektrischen Isolator, einer fünften Schicht (330) aus einem elektrischen Leiter, wobei die fünfte Schicht (330) mindestens einen Abschnitt (A) beinhaltet, der fähig ist, ein elektronisches Bauteil (140) aufzunehmen;
- Einbringen von Wärmedurchgangslöchern (361, 362) zwischen dem Abschnitt (A), der fähig ist, Bauteile aufzunehmen, der fünften elektrischen Leiterschicht (330) und der dritten elektrischen Leiterschicht (323);
- Befestigen des zweiten Stapelaufbaus auf dem ersten Stapelaufbau, wobei sich die dritte Schicht (323) auf der zweiten elektrischen Isolatorschicht (320) befindet, **dadurch gekennzeichnet, dass** die Wärmedurchgangslöcher (361, 362) zwischen dem Abschnitt (A), der fähig ist, Bauteile aufzunehmen, der fünften elektrischen Leiterschicht (330) und der dritten elektrischen Leiterschicht (323) so eingebracht werden, dass entweder die Wärmedurchgangslöcher (361, 362) in der fünften elektrischen Leiterschicht (330) und der vierten elektrischen Isolatorschicht (327) durchgehend und in der dritten elektrischen Leiterschicht (323) nicht durchgehend sind oder die Wärmedurchgangslöcher (361, 362) in der dritten elektrischen Leiterschicht (323) und der vierten elektrischen Isolatorschicht (327) durchgehend und in der fünften elektrischen Leiterschicht (330) nicht durchgehend sind.

9. Verfahren zur Herstellung eines elektronischen Schaltkreises nach Anspruch 8, wobei das Einbringen der Wärmedurchgangslöcher das Verschließen der Löcher (361) mit einem wärmeleitenden Material beinhaltet.

10. Verfahren zur Herstellung eines elektronischen Schaltkreises nach Anspruch 8, wobei das Einbringen der Wärmedurchgangslöcher das Aufbringen einer Beschichtung aus einem wärmeleitenden Material auf die Wände der Löcher (362) beinhaltet.

11. Verfahren zur Herstellung eines elektronischen Schaltkreises nach einem der Ansprüche 8 bis 10, wobei das Befestigen des zweiten Stapelaufbaus auf dem ersten Stapelaufbau das Pressen des zweiten Stapelaufbaus auf den ersten Stapelaufbau beinhaltet.

## Claims

1. Electronic circuit board (300) comprising at least:
a first layer (310), of a thermal conductor;
a second layer (320), of an electrical insulator;
a third layer (323), of an electrical conductor;
a fourth layer (327), of an electrical insulator;
a fifth layer (330), of an electrical conductor, said fifth layer (330), of electrical conductor, comprising at least one portion (A) capable of accepting an electronic component (140);
wherein a plurality of thermal interconnect holes (361, 362) connect the portion (A) of the fifth layer (330), of electrical conductor, to the third layer (323), of electrical conductor,
**characterized in that** the thermal interconnect holes (361, 362) either pass through the fifth layer (330), of electrical conductor, and the fourth layer (327), of electrical insulator, and do not pass through the third layer (323), of electrical conductor, or pass through the third layer (323), of electrical conductor, and the fourth layer (327), of electrical insulator, and do not pass through the fifth layer (330), of electrical conductor.

2. Electronic circuit board according to the preceding claim, wherein the thermal interconnect holes are holes (361) filled with a thermally conductive material.

3. Electronic circuit board according to Claim 1, wherein the thermal interconnect holes are holes (362) comprising an inner coating of a first thermally conductive material.

4. Electronic circuit board according to Claim 3, wherein the holes (362) further comprise, in their centre part, a second thermally conductive material.

5. Electronic circuit board according to one of Claims 1 to 4, wherein the thermal interconnect holes (361, 362) are distributed in a peripheral zone of the portion (A) capable of accepting an electronic component.

6. Electronic circuit board according to one of Claims 1 to 4, wherein the thermal interconnect holes (361, 362) are distributed over the entirety of the portion (A) capable of accepting an electronic component.

7. Electronic circuit board according to one of the preceding claims, further comprising, between a layer of electrical insulator (320, 327) and a layer of electrical conductor (323, 330), a plurality of layers of electrical conductor that are separated from one another by layers of electrical insulator, thermal interconnect holes (361, 362) connecting the electrical conduction layers to one another.

8. Process for producing an electronic circuit board, comprising:
- providing a first stack of a first layer (310), of thermal conductor, and of a second layer (320), of electrical insulator;
- providing a second stack of a third layer (323), of an electrical conductor, of a fourth layer (327), of an electrical insulator, and of a fifth layer (330), of an electrical conductor, the fifth layer (330) comprising at least one portion (A) capable of accepting an electronic component (140) ;
- producing thermal interconnect holes (361, 362) between the portion (A) capable of accepting components of the fifth layer (330), of electrical conductor, and the third layer (323), of electrical insulator;
- attaching the second stack to the first stack, the third layer (323) being on top of the second layer (320), of electrical insulator, **characterized in that** the thermal interconnect holes (361, 362) between the portion (A) capable of accepting components of the fifth layer (330), of electrical conductor, and the third layer (323), of electrical conductor, are produced such that either the thermal interconnect holes (361, 362) pass through the fifth layer (330), of electrical conductor, and the fourth layer (327), of electrical insulator, and do not pass through the third layer (323), of electrical conductor, or the thermal interconnect holes (361, 362) pass through the third layer (323), of electrical conductor, and the fourth layer (327), of electrical insulator, and do not pass through the fifth layer (330), of electrical conductor.

9. Process for producing an electronic circuit board according to Claim 8, wherein producing the thermal interconnect holes comprises plugging the holes (361) with a thermally conductive material.

10. Process for producing an electronic circuit board according to Claim 8, wherein producing the thermal interconnect holes comprises depositing a coating of thermally conductive material on the walls of the holes (362).

11. Process for producing an electronic circuit board according to one of Claims 8 to 10, wherein attaching the second stack to the first stack comprises laminating the second stack onto the first stack.
